# EUROPÄISCHE PATENTSCHRIFT

(11) **EP 1 118 081 B1**
(45) Veröffentlichungstag und Bekanntmachung des Hinweises auf die Patenterteilung: **04.12.2002**
(21) Anmeldenummer: 99969821.0
(22) Anmeldetag: 13.09.1999
(51) Int. Cl.: G11C 11/22, G11C 7/12, G11C 7/22

(54) **INTEGRIERTER SPEICHER MIT EINEM DIFFERENTIELLEN LESEVERSTÄRKER**
INTEGRATED MEMORY WITH DIFFERENTIAL READ AMPLIFIER
MEMOIRE INTEGREE DOTEE D'UN AMPLIFICATEUR DE LECTURE DIFFERENTIEL

(30) Priorität: 28.09.1998 DE 19844479
(43) Veröffentlichungstag der Anmeldung: 25.07.2001
(73) Patentinhaber: Infineon Technologies AG, 81669 München (DE)
(72) Erfinder: RÖHR, Thomas, D-85609 Aschheim (DE); BÖHM, Thomas, D-85604 Zorneding (DE); HÖNIGSCHMID, Heinz, D-82319 Starnberg (DE); BRAUN, Georg, D-80339 München (DE)
(74) Vertreter: Fischer, Volker, Dipl.-Ing.
(86) Internationale Anmeldenummer: DE9902888
(87) Internationale Veröffentlichungsnummer: WO00019442

(56) Entgegenhaltungen:
- DE-A- 4 118 847
- US-A- 5 487 043

## Beschreibung

Die Erfindung betrifft einen integrierten Speicher nach dem Oberbegriff des Patentanspruches 1.

Differentielle Leseverstärker (Sense Amplifier) werden beispielsweise in DRAMs und FRAMs (Ferroelektrische RAMs) zum Verstärken von aus Speicherzellen ausgelesenen Daten und zum Einschreiben von Daten in die Speicherzellen eingesetzt. In der US 5,241,503 A ist ein solcher Leseverstärker beschrieben. Er ist mit den Speicherzellen über ein Bitleitungspaar verbunden, das zur Übertragung eines Differenzsignals dient. Die Bitleitungen werden vor einem Lesezugriff auf bestimmte Potentiale vorgeladen, bevor eine der Speicherzellen mit einer der Bitleitungen leitend verbunden wird und deren Potential beeinflußt. Anschließend wird der Leseverstärker aktiviert, so daß er die Potentialdifferenz zwischen den beiden Bitleitungen verstärkt und die Bitleitungen anschließend entgegengesetzte logische Pegel aufweisen. Da beim Auslesen einer DRAM-Speicherzelle ihr Speicherzelleninhalt verloren geht (Zerstörendes Lesen), wird üblicherweise das vom Leseverstärker beim Lesezugriff verstärkte Signal in die zuvor ausgelesene Speicherzelle zurückgeschrieben. Auf diese Weise wird ihr ursprünglicher Speicherzustand wieder hergestellt.

Ein Schreibzugriff unterscheidet sich bei einem DRAM oder FRAM von einem Lesezugriff nur geringfügig. Der hauptsächliche Unterschied besteht darin, daß bei einem Lesezugriff der Leseverstärker das verstärkte Differenzsignal nach außerhalb des Speichers weitergibt, während bei einem Schreibzugriff von außerhalb des Speichers ein Differenzsignal, das einem einzuschreibenden Datum entspricht, dem Leseverstärker zugeführt wird, der auf dem mit ihm verbundenen Bitleitungspaar entsprechende Potentialzustände einstellt. Sowohl zu Beginn eines Lese- als auch eines Schreibzugriffs erfolgt Üblicherweise ein Vorladen der Bitleitungen in gleicher Weise, d.h. mit denselben Schritten. Ein Schreib- und ein Lesezugriff unterscheiden sich daher nur darin, ob nach dem Vorladen der Bitleitungen von außerhalb des Speichers zugeführte Daten vom Leseverstärker auf die Bitleitungen gegeben werden, oder ob der Leseverstärker das beim Auslesen der Speicherzelle auf dem Bitleitungspaar entstehende Differenzsignal verstärkt nach außerhalb weitergibt.

Der soeben beschriebene Ablauf eines Schreib- und eines Lesezyklus bei einem DRAM oder FRAM hat den Vorteil, daß die Ansteuerung zur Vorladung der Bitleitungen und zum leitenden Verbinden der Speicherzellen mit einer der Bitleitungen in beiden Fällen auf genau die gleiche Weise erfolgt. Daher dauert ein Schreibzugriff bei den koventionellen Speichern mit zerstörendem Lesen ebensolange wie ein Lesezugriff.

Aus US-A-5,487,043 ist ein Speicher bekannt, in dem ein Vorladen von Bitleitungen auf ein Vorladepotential über ein Signal vorgenommen wird, das gleichzeitig einen Ladungsausgleich über zwei Transistoren ausführt.

Der Erfindung liegt die Aufgabe zugrunde, einen integrierten Speicher anzugeben, bei dem ein schneller Schreibzugriff erfolgt.

Diese Aufgabe wird bei der eingangs genannten Art erfindungsgemäß durch das im kennzeichnenden Teil des Patentanspruches 1 angegebene Merkmal gelöst. Vorteilhafte Aus- und Weiterbildungen der Erfindung sind Gegenstand der abhängigen Ansprüche 2 bis 6.

Der erfindungsgemäße integrierte Speicher weist beschreibbare Speicherzellen auf. Außerdem weist er ein Paar von Bitleitungen auf, das die Speicherzellen mit einem differentiellen Leseverstärker verbindet, über den bei einem Lesegriff auszulesende Daten von den Speicherzellen nach außerhalb des Speichers und bei einem Schreibzugriff einzuschreibende Daten von außerhalb des Speichers zu den Speicherzellen übertragen werden. Weiterhin weist er eine Steuereinheit zum Vorladen der Bitleitungen in mehreren Schritten auf, bevor bei einem Lesezugriff eine der Speicherzellen mit einer der Bitleitungen leitend verbunden wird. Die Steuereinheit führt bei einem Schreibzugriff höchsten einen Teil der für einen Lesezugriff vorgesehenen Schritte des Vorladens der Bitleitungen durch, bevor der Leseverstärker Daten zum Bitleitungspaar übermittelt.

Da bei einem Schreibzugriff das Vorladen der Bitleitungen, das bei einem Lesezugriff durchgeführt wird, entweder vollständig oder zumindest teilweise entfällt, wird vorteilhaft ein Schreibzugriff erreicht, zu dessen Durchführung weniger Zeit benötigt wird, als zur Durchführung eines Lesezugriffs. Der erfindungsgemäße Speicher kann also schneller beschrieben werden, als konventionelle Speicher.

Die Erfindung ist allgemein auf beschreibare integrierte Speicher mit Differenzverstärkern anwendbar.

Nach einer Weiterbildung werden die Speicherzelleninhalte der Speicherzellen bei einem Lesezugriff zerstört, das heißt es handelt sich um ein zerstörendes Lesen. Der Leseverstärker verstärkt bei einem Lesezugriff das sich nach dem leitenden Verbinden der Speicherzelle mit der Bitleitung einstellende Differenzsignal auf dem Bitleitungspaar und schreibt es dabei zurück in die Speicherzelle.

Speicher mit zerstörenden Lesezugriffen sind beispielsweise DRAMs und FRAMs. Bei diesen erfolgt sowohl beim Lesen als auch beim Schreiben ein den Speicherzugriff abschließendes Einschreiben von Daten in die Speicherzellen. Erfindungsgemäß erfolgt bei einem Schreibzugriff die Durchführung höchstens eines Teiles der Schritte, die bei einem Lesezugriff für das Vorladen der Bitleitungen erforderlich sind. Somit unterscheidet sich ein Schreibzugriff vom Lesezugriffes durch die Schritte des Vorladens, die dem bei beiden Zugriffsarten erfolgenden Schreiben vorausgehen.

Nach einer Weiterbildung der Erfindung wird während eines Lesezugriffs vor einer Aktivierung des Leseverstärkers die jeweilige Speicherzelle ausgelesen, indem sie mit einer der Bitleitungen leitend verbunden wird. Außerdem erfolgt während eines Schreibzugriffs zunächst eine Aktivierung des Leseverstärkers, so daß einzuschreibende Daten bereits auf dem Bitleitungspaar vorliegen, bevor die jeweilige Speicherzelle mit einer der Bitleitungen leitend verbunden wird.

Während also der Lesezugriff wie bei herkömmlichen DRAMs oder FRAMs erfolgt, wird bei einem Schreibzugriff zunächst der Leseverstärker aktiviert, bevor die Speicherzelle leitend mit einer der Bitleitungen verbunden wird. Dies hat den Vorteil, daß mit einer Aktivierung des Leseverstärkers und dem damit verbundenen eventuellen Umladen der Bitleitung nicht so lange gewartet werden muß, bis die jeweilige Speicherzelle bereits leitend mit der entsprechenden Bitleitung verbunden ist. Zum Einschreiben eines Datums in eine der Speicherzellen, nachdem der Leseverstärker aktiviert worden ist, genügt dann ein kurzzeitiges leitendes Verbinden der Speicherzelle mit der entsprechenden Bitleitung.

Die Erfindung wird im folgenden anhand der Figuren näher erläutert.
- Figur 1: zeigt ein Ausführungsbeispiel des erfindungsgemäßen integrierten Speichers und
- Figur 2: zeigt Signalverläufe auf in Figur 1 dargestellten Bitleitungen während eines Schreibzugriffs und während eines Lesezugriffs.

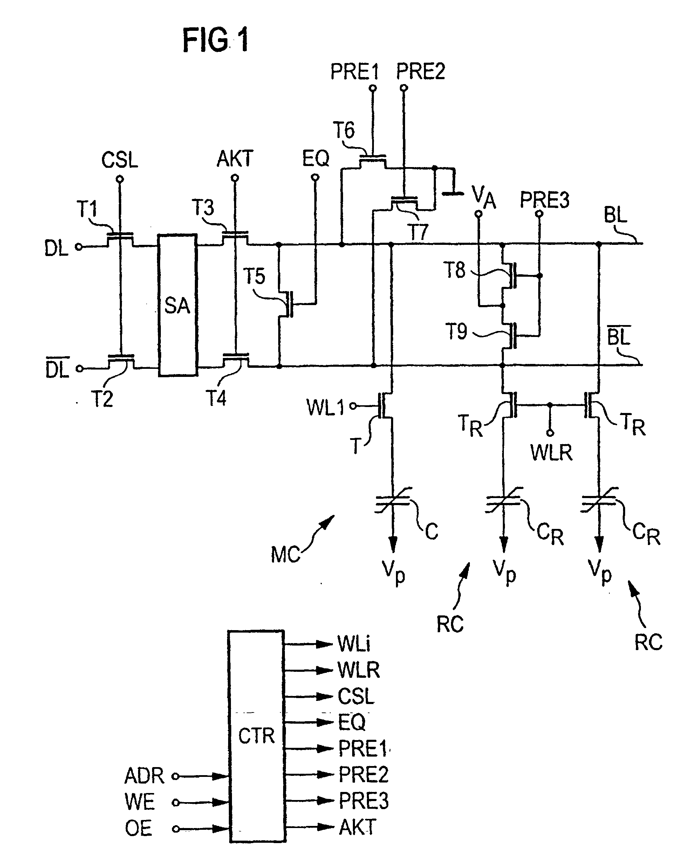

Figur 1 zeigt die für das Verständnis der Erfindung notwendigen Komponenten eines FRAMs. Das FRAM weist einen differentiellen Leseverstärker SA auf, der beispielsweise wie derjenige in der US 5,241,503 gestaltet sein kann. Der Leseverstärker SA verbindet ein differentielles Datenleitungspaar DL, /DL mit einem differentiellen Bitleitungspaar BL, /BL. Über das Datenleitungspaar DL, /DL ist der Leseverstärker SA mit externen Anschlüssen des Speichers verbunden (in Figur 1 nicht dargestellt). Über die Bitleitungen BL, /BL ist der Leseverstärker SA mit Speicherzellen MC verbunden, von denen in Figur 1 nur eine dargestellt wurde. Jede Speicherzelle weist einen Auswahltransistor T vom n-Kanal-Typ sowie einen Speicherkondensator C mit einem ferroelektrischen Dielektrikum auf. Der Auswahltransistor T und der Speicherkondensator C sind in einer Reihenschaltung zwischen einer der Bitleitungen BL und einem Plattenpotential V_{P} angeordnet. Das Gate des Auswahltransistors T ist mit einer wortleitung WL1 verbunden. Jede Bitleitung BL, /BL ist mit einer Vielzahl der Speicherzellen MC verbunden. Eine Auswahl einer der Speicherzellen erfolgt über die jeweilige Wortleitung WL1.

Außerdem ist jede der Bitleitungen BL, /BL mit einer Referenzzelle RC verbunden, die ebenso aufgebaut ist wie die Speicherzellen MC. Jede Referenzzelle RC weist daher ebenfalls einen Auswahltransistor T_{R} und einen Speicherkondensator C_{R} auf, die genauso wie die Transistoren T und Kondensatoren C der Speicherzellen MC dimensioniert sind. Die Gates der Auswahltransistoren T_{R} der Referenzzellen RC sind mit einer Referenzwortleitung WLR verbunden.

Der Leseverstärker SA ist über einen ersten Transistor T1 bzw. einen zweiten Transistor T2 mit den Datenleitungen DL, /DL verbunden. Die Gates der beiden Transistoren T1, T2 sind mit einem Spaltenauswahlsignal CSL verbunden, das in Abhängigkeit von an den Speicher anlegbaren Spaltenadressen aktivierbar ist. Der Leseverstärker SA ist über einen dritten Transistor T3 bzw. einen vierten Transistor T4 mit den Bitleitungen BL, /BL verbunden. Die Gates dieser beiden Transistoren T3, T4 sind mit einem Aktivierungssignal AKT verbunden. Außerdem sind die beiden Bitleitungen BL, /BL über einen fünften Transistor T5 miteinander verbunden, dessen Gate mit einem Ausgleichsignal EQ verbunden ist. Weiterhin ist die erste Bitleitung BL über einen sechsten Transistor T6 mit Masse verbunden, dessen Gate mit einem ersten Vorladesignal PRE1 verbunden ist. Die zweite Bitleitung /BL ist über einen siebten Transistor T7 mit Masse verbunden, dessen Gate mit einem zweiten Vorladesignal PRE2 verbunden ist.

Ferner sind die erste Bitleitung BL und die zweite Bitleitung /BL über eine Reihenschaltung eines achten T8 und eines neunten T9 Transistors miteinander verbunden. Die Gates dieser Transistoren T8, T9 sind mit einem dritten Vorladesignal PRE3 verbunden. Ein Schaltungsknoten zwischen den beiden Transistoren T8, T9 ist mit einem Vorladepotential V_{A} verbunden. Die Transistoren T1 bis T9 in Figur 1 sind n-Kanal-Transistoren.

Während das Spaltenauswahlsignal CSL aktiv ist, werden bei einem Lesezugriff die Daten aus dem Leseverstärker auf die Datenleitungen DL, /DL ausgelesen, bei einem Schreibzugriff werden die Daten jedoch von außen über die Datenleitungen DL, /DL in den Leseverstärker eingeprägt. Bei einem herkömmlichen Speicher unterscheiden sich ein Lese- und ein Schreibzugriff nur durch die Richtung, in der die Daten während der Aktivierung des Spaltenauswahlsignals CSL ausgetauscht werden. Bei der Erfindung bestehen weitere Unterschiede, die im folgenden erläutert werden.

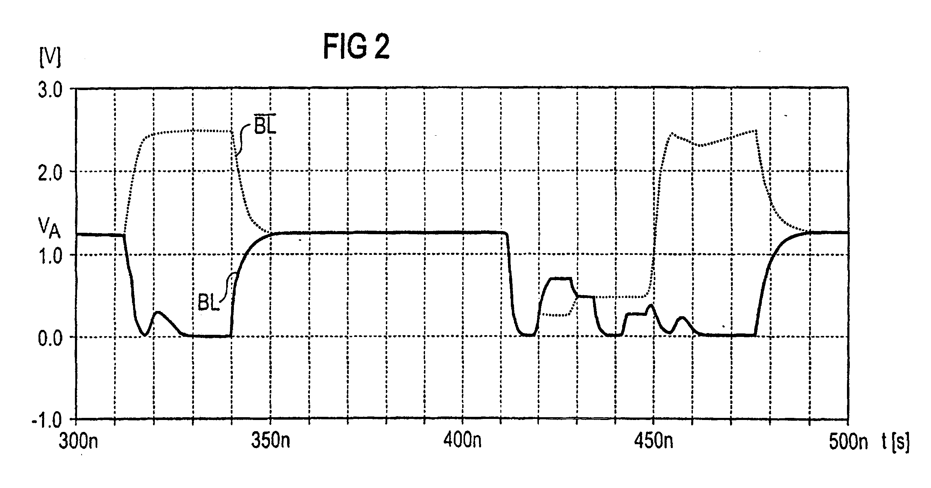

Der Speicher weist eine Steuereinheit CTR auf, der Speicherzellenadressen ADR, ein Schreibsignal WE sowie ein Lesesignal OE zugeführt werden. An ihren Ausgängen erzeugt die Steuereinheit CTR das Aktivierungssignal AKT, das Ausgleichsignal EQ, das Spaltenauswahlsignal CSL, das erste Vorladesignal PRE1, das zweite Vorladesignal PRE2 und das dritte Vorladesignal PRE3. Außerdem ist die Steuereinheit CTR über ihre Ausgänge mit den Wortleitungen WLi und der Referenzwortleitung WLR verbunden. Die Steuereinheit CTR aktiviert das Spaltenauswahlsignal CSL und die Wortleitungen WLi in Abhängigkeit von der anliegenden Adresse ADR. Über das Schreibsignal WE wird ein Schreibzugriff und über das Lesesignal OE ein Lesezugriff gestartet. Je nachdem, ob es sich um einen Lese- oder einen Schreibzugriff handelt, steuert die Steuereinheit CTR einen Großteil ihrer Ausgangssignale in unterschiedlicher Weise. Dies wird im folgenden anhand der Figur 2 erläutert.

Figur 2 zeigt den Potentialverlauf des Potentials auf den beiden Bitleitungen BL, /BL während eines Schreibzugriffs (linke Hälfte) und während eines Lesezugriffs (rechte Hälfte). Figur 2 ist zu entnehmen, daß zu Beginn des Schreibzugriffs beide Bitleitungen BL, /BL über das dritte Vorladesignal PRE3 auf das Vorladepotential V_{A} = 1,2 Volt vorgeladen worden sind. Vor dem Schreibzugriff werden das Ausgleichsignal EQ, das erste Vorladesignal PRE1, das zweite Vorladesignal PRE2 sowie die Referenzwortleitung WLR nicht aktiviert, so daß die mit ihnen verbundenen Transistoren nicht leitend geschaltet werden. Im betrachteten Fall soll eine logische "0" in die mit der ersten Bitleitung BL verbundene Speicherzelle MC aus Figur 1 eingeschrieben werden. Ein entsprechendes differentielles Datensignal ist bereits von außerhalb des Speichers über die Datenleitungen DL, /DL und den ersten Tansistor T1 bzw. den zweiten Transistor T2, die über das Spaltenauswahlsignal CSL leitend geschaltet worden sind, zum Leseverstärker SA übertragen worden, der ein entsprechendes Differenzsignal an seinen den Bitleitungen BL, /BL zugewandten Anschlüssen erzeugt. Kurz nach dem Zeitpunkt 310 ns werden der dritte Transistor T3 und der vierte Transistor T4 über das Aktivierungssignal AKT leitend geschaltet, so daß der Leseverstärker SA das einzuschreibende Differenzsignal auf die Bitleitungen BL, /BL weitergibt. Das Verbinden des Leseverstärkers SA über die beiden Transistoren T3, T4 mit den Bitleitungen BL, /BL wird hier auch als "Aktivierung" des Leseverstärkers bezeichnet.

Figur 2 ist zu entnehmen, daß als Folge der Aktivierung des Leseverstärkers die erste Bitleitung BL allmählich einen niedrigen Pegel von 0 Volt und die zweite Bitleitung /BL allmählich einen hohen Pegel von 2,5 Volt annimmt. Kurz vor dem Zeitpunkt 320 ns wird die Wortleitung WL1 auf ein hohes Potential gebracht, so daß der Auswahltransistor T der Speicherzelle MC leitend mit der ersten Bitleitung BL verbunden wird. Da in diesem Fall vor dem Öffnen des Auswahltransistors T eine logische "1" in der Speicherzelle MC gespeichert war, ergibt sich bei 320 ns eine kurze Delle im Potentialverlauf der ersten Bitleitung BL. Aufgrund des Ladungsausgleichs zwischen der ersten Bitleitung BL und der mit ihr verbundenen Elektrode des Speicherkondensators C ist die logische "0" ungefähr bei 330 ns sicher in der Speicherzelle MC gespeichert.

Figur 2 zeigt ab dem Zeitpunkt 400 ns die Durchführung eines Lesezugriffs auf die Speicherzelle MC in Figur 1, in der zuvor, wie soeben beschrieben, eine logische "0" gespeichert worden ist. Bei 410 ns werden zunächst beide Bitleitungen BL, /BL über den sechsten Transistor T6 und den siebten Tansistor T7 in Abhängigkeit vom ersten Vorladesignal PRE1 und zweiten Vorladesignal PRE2 auf Masse entladen. Bei 420 ns werden die Referenzzellen RC über die Referenzwortleitung WLR leitend mit der jeweiligen Bitleitung BL, /BL verbunden. Dabei war die mit der ersten Bitleitung BL verbundene Referenzzelle RC zuvor auf eine logische "1" und die mit der zweiten Bitleitung /BL verbundene Referenzzelle RC auf eine logische "0" vorgeladen. Daher ergibt sich nach dem Zeitpunkt 420 ns ein unterschiedliches Potential auf den beiden Bitleitungen BL, /BL. Das erste PRE1 und das zweite PRE2 Vorladesignal nehmen wieder einen niedrigen Pegel an, während bei 430 ns das Ausgleichsignal EQ einen hohen Pegel annimmt. Dadurch erfolgt ein Ladungsausgleich auf den beiden Bitleitungen BL, /BL über den fünften Transistor T5. Bei etwa 435 ns, nachdem das Ausgleichsignal EQ wieder einen niedrigen Pegel angenommen hat, wird die erste Bitleitung BL auf Masse entladen, indem sie über den sechsten Transistor T6 mit einem hohen Pegel des ersten Vorladesignals PRE1 mit Masse verbunden wird. Erst kurz nach 440 ns wird die Speicherzelle MC über die Wortleitung WL1 leitend mit der ersten Bitleitung BL verbunden, wodurch das Potential dieser aufgrund der in der Speicherzelle MC gespeicherten logischen "0" nur geringfügig ansteigt. Bei 450 ns wird der Leseverstärker SA aktiviert, indem er über die mit dem Aktivierungssignal AKT angesteuerten Transistoren T3, T4 mit dem Bitleitungspaar BL, /BL verbunden wird. Zu diesem Zeitpunkt detektiert der Leseverstärker SA das Vorzeichen der Potentialdifferenz zwischen den beiden Bitleitungen BL, /BL und verstärkt dieses Differenzsignal, so daß kurz nach 450 ns die erste Bitleitung BL ein niedriges Potential von 0 Volt und die zweite Bitleitung /BL ein hohes Potential von ungefähr 2,5 Volt aufweist. Der Leseverstärker SA gibt anschließend dieses verstärkte Differenzsignal über die mit dem Spaltenauswahlsignal CSL angesteuerten Transistoren T1, T2 an die Datenleitungen DL, /DL weiter. Da der Auswahltransistor T nach dem Zeitpunkt 450 ns zunächst weiterhin über seine Wortleitung WL1 leitend geschaltet ist, wird die ausgelesene logische "0" automatisch wieder vom Leseverstärker SA während des Verstärkens des Differenzsignals in die Speicherzelle MC zurückgeschrieben. Kurz vor 480 ns wird der Leseverstärker SA wieder deaktiviert, indem das Aktivierungssignal AKT einen niedrigen Pegel aufweist. Anschließend wird wieder über das dritte Vorladesignal PRE3 ein Vorladen der Bitleitungen BL, /BL auf das Vorladepotential V_{A} durchgeführt. Danach kann ein neuer Schreib- oder Lesezugriff auf eine der mit dem Bitleitungspaar BL, /BL verbundenen Speicherzellen MC durchgeführt werden

Figur 2 ist zu entnehmen, daß der gesamte Schreibzugriff bei diesem Ausführungsbeispiel lediglich 40 ns dauert, während der Lesezugriff nahezu 80 ns dauert. Damit erfolgt ein Schreibzugriff bei diesem Speicher nahezu doppelt so schnell wie ein Lesezugriff. Dies wird dadurch erreicht, daß vor dem Schreibzugriff die beim Lesezugriff durchgeführten Schritte des Vorladens der Bitleitungen nahezu vollständig entfallen, bis auf das Vorladen der beiden Bitleitungen auf das Vorladepotential V_{A}. Es entfallen das Entladen der beiden Bitleitungen auf 0 Volt über die beiden Vorladesignale PRE1, PRE2, das Auslesen der Referenzspeicherzellen RC über die Referenzwortleitung WLR, der anschließende Ladungsausgleich zwischen den Bitleitungen BL, /BL über das Ausgleichsignal EQ sowie das Entladen der ersten Bitleitung BL über das erste Vorladesignal PRE1, kurz vor dem leitenden Verbinden der Speicherzelle MC mit der ersten Bitleitung BL. Diese Schritte des Vorladens der Bitleitungen sind nur bei einem Lesezugriff eines FRAMs notwendig und können daher beim Schreibzugriff entfallen. Allerdings erfordert dies eine unterschiedliche Erzeugung der für das Vorladen benötigten Signale durch die Steuereinheit CTR während des Schreibzugriffs im Vergleich zum Lesezugriff.

Bei einem herkömmlichen Speicher wäre die für den Schreibzugriff benötigte Zeit ebenso lang wie die für einen Lesezugriff benötigte Zeit. Da bei herkömmlichen Speichern sich die Art des Speicherzugriffs nur darin unterscheidet, ob dem Leseverstärker SA bei einem hohen Pegel des Auswahlsignals CSL von außerhalb des Speichers eine einzuschreibende Information aufgezwungen wird oder nicht, erfolgt bei herkömmlichen Speichern sowohl bei einem Schreib- als auch bei einem Lesezugriff ein Vorladen der Bitleitungen mit jeweils den gleichen Schritten.

Da bei diesem Ausführungsbeispiel das Auslesen der Referenzzellen RC nur bei jedem Lesezugriff, jedoch bei keinem Schreibzugriff durchgeführt wird, ist vorteilhafterweise die Anzahl der Zugriffe auf die Referenzzellen geringer als bei herkömmlichen FRAMs. Da FRAM-Speicherzellen bekanntlich in Abhängigkeit der Speicherzellenzugriffe altern, wird der Alterungsprozeß der Referenzzellen des hier beschriebenen Speichers verlangsamt. Da jeder Bitleitung BL eine große Anzahl von Speicherzellen MC, aber nur eine Referenzzelle zugeordnet ist, erfolgt bei herkömmlichen FRAMs mit derartigen Referenzzellen ein Zugriff auf diese bei jedem Lesezugriff und bei jedem Schreibzugriff. Beim erfindungsgemäßen FRAM erfolgt ein Zugriff auf die Referenzzellen RC nur bei den Lesezugriffen und nicht bei einem Schreibzugriff.

## Patentansprüche

1. Integrierter Speicher
- mit beschreibbaren Speicherzellen (MC),
- mit einem Paar von Bitleitungen (BL, /BL), das die Speicherzellen (MC) mit einem differentiellen Leseverstärker (SA) verbindet, über den bei einem Lesezugriff auszulesende Daten von den Speicherzellen nach außerhalb des Speichers und bei einem Schreibzugriff einzuschreibende Daten von außerhalb des Speichers zu den Speicherzellen übertragen werden,
- und mit einer Steuereinheit (CTR) zum Vorladen der Bitleitungen (BL, /BL) in mehreren Schritten, bevor bei einem Lesezugriff eine der Speicherzellen (MC) mit einer der Bitleitungen (BL) leitend verbunden wird,
**dadurch gekennzeichnet,**
- **daß** die Steuereinheit (CTR) bei einem Schreibzugriff höchstens einen Teil der für einen Lesezugriff vorgesehenen Schritte des Vorladens der Bitleitungen (BL, /BL) durchführt, bevor der Leseverstärker (SA) Daten zum Bitleitungspaar (BL, /BL) übermittelt.

2. Integrierter Speicher nach Anspruch 1,
- bei dem die Speicherzelleninhalte der Speicherzellen bei einem Lesezugriff zerstört wird
- und dessen Leseverstärker (SA) das sich bei einem Lesezugriff nach dem leitenden Verbinden der Speicherzelle (MC) mit der Bitleitung (BL) einstellende Differenzsignal auf dem Bitleitungspaar (BL, /BL) verstärkt und dabei zurück in die Speicherzelle schreibt.

3. Integrierter Speicher nach Anspruch 1,
dessen Steuereinheit (CTR) bei einem Lesezugriff zum Vorladen der Bitleitungen (BL, /BL) ein Vorladen beider Bitleitungen (BL, /BL) auf ein gemeinsames Potential durchführt, das bei einem Schreibzugriff entfällt.

4. Integrierter Speicher nach einem der vorstehenden Ansprüche,
dessen Steuereinheit (CTR) bei einem Lesezugriff zum Vorladen der Bitleitungen (BL, /BL) ein Auslesen von Referenzspeicherzellen (RC) auf die Bitleitungen (BL, /BL) und einen anschließenden Ladungsausgleich zwischen den Bitleitungen durchführt, wobei beide Vorgänge bei einem Schreibzugriff entfallen.

5. Integrierter Speicher nach Anspruch 4,
dessen Steuereinheit (CTR) bei einem Lesezugriff zum Vorladen der Bitleitungen (BL, /BL) ein Entladen der mit der zu lesenden Speicherzelle (MC) verbundenen Bitleitung (BL) durchführt, das zeitlich auf den Ladungsausgleich zwischen den Bitleitungen (BL, /BL) folgt und das bei einem Schreibzugriff entfällt.

6. Integrierter Speicher nach einem der vorstehenden Ansprüche,
- bei dem während eines Lesezugriffs vor einer Aktivierung des Leseverstärkers (SA) die jeweilige Speicherzelle (MC) ausgelesen wird, indem sie mit einer der Bitleitungen (BL, /BL) leitend verbunden wird,
- und bei dem während eines Schreibzugriffs zunächst eine Aktivierung des Leseverstärkers (SA) erfolgt, so daß einzuschreibenden Daten bereits auf dem Bitleitungspaar (BL, /BL) vorliegen, bevor die jeweilige Speicherzelle (MC) mit einer der Bitleitungen (BL) leitend verbunden wird.

## Claims

1. Integrated memory
- having writable memory cells (MC),
- having a pair of bit lines (BL, /BL) which connects the memory cells (MC) to a differential sense amplifier (SA) which is used to transfer data which are to be read during a read access operation from the memory cells to outside the memory, and which is used to transfer data which are to be written during a write access operation from outside the memory to the memory cells,
- and having a control unit (CTR) for precharging the bit lines (BL, /BL) in a plurality of steps before one of the memory cells (MC) is conductively connected to one of the bit lines (BL) for a read access operation,
**characterized**
- **in that**, for a write access operation, the control unit (CTR) carries out no more than some of the bit line (BL, /BL) precharging steps provided for a read access operation before the sense amplifier (SA) transfers data to the bit line pair (BL, /BL).

2. Integrated memory according to Claim 1,
- in which the memory cell contents of the memory cells are destroyed during a read access operation,
- and whose sense amplifier (SA) amplifies the difference signal established on the bit line pair (BL, /BL) during a read access operation when the memory cell (MC) has been conductively connected to the bit line (BL), and then writes it back to the memory cell.

3. Integrated memory according to Claim 1, whose control unit (CTR), in order to precharge the bit lines (BL, /BL) for a read access operation, precharges both bit lines (BL, /BL) to a common potential which is dispensed with for a write access operation.

4. Integrated memory according to one of the preceding claims,
whose control unit (CTR), in order to precharge the bit lines (BL, /BL) for a read access operation, reads out reference memory cells (RC) onto the bit lines (BL, /BL) and then performs charge equalization between the bit lines, both operations being dispensed with for a write access operation.

5. Integrated memory according to Claim 4,
whose control unit (CTR), in order to precharge the bit lines (BL, /BL) for a read access operation, discharges the bit line (BL) connected to the memory cell (MC) which is to be read, said discharge being effected at a time after the charge equalization between the bit lines (BL, /BL) and being dispensed with for a write access operation.

6. Integrated memory according to one of the preceding claims,
- in which, during a read access operation, the respective memory cell (MC) is read by conductively connecting it to one of the bit lines (BL, /BL) before the sense amplifier (SA) is activated,
- and in which, during a write access operation, the sense amplifier (SA) is activated first, so that data which are to be written are already present on the bit line pair (BL, /BL) before the respective memory cell (MC) is conductively connected to one of the bit lines (BL).

## Revendications

1. Mémoire intégrée
- comprenant des cellules (MC) de mémoire dans lesquelles on peut écrire,
- comprenant une paire de lignes (BL, /BL) de bits, qui relie les cellules (MC) de mémoire à un amplificateur (SA) de lecture différentiel, par lequel des données à lire lors d'un accès en lecture sont transmises des cellules de mémoire à l'extérieur de la mémoire et des données à écrire lors d'un accès en écriture sont transmises de l'extérieur de la mémoire aux cellules de mémoire
- et comprenant une unité (CTR) de commande pour précharger les lignes (BL, /BL) de bits en plusieurs stades avant de relier de manière conductrice lors d'un accès en lecture l'une des cellules (MC) de mémoire à l'une des lignes (BL) de bits,
**caractérisée**
- **en ce que** l'unité (CTR) de commande effectue lors d'un accès en lecture au plus une partie des stades du préchargement des lignes (BL, /BL) de bits qui sont prévus pour un accès en lecture avant que l'amplificateur (SA) de lecture ne transmette des données à la paire (BL, /BL) de lignes de bits.

2. Mémoire intégrée suivant la revendication 1,
- dans laquelle le contenu des cellules de mémoire est détruit lors d'un accès en lecture
- et dont l'amplificateur (SA) de lecture amplifie le signal différentiel sur la paire (BL, /BL) de lignes de bits qui s'établit lors d'un accès en lecture après la liaison conductrice de la cellule (MC) de mémoire à la ligne (BL) de bits et écrit ainsi en retour dans la cellule de mémoire.

3. Mémoire intégrée suivant la revendication 1
dont l'unité (CTR) de commande effectue lors d'un accès en lecture pour le préchargement des lignes (BL, /BL) de bits, un préchargement des deux lignes (BL, /BL) de bits à un potentiel commun qui cesse lors d'un accès en écriture.

4. Mémoire intégrée suivant l'une des revendications précédentes
dont l'unité (CTR) de commande effectue lors d'un accès en lecture pour le préchargement des lignes (BL, /BL) de bits une lecture de cellules (RC) de mémoire de référence sur les lignes (BL, /BL) de bits et une comparaison de charge venant ensuite entre les lignes de bits, les deux opérations cessant lors d'un accès en écriture.

5. Mémoire intégrée suivant la revendication 4,
dont l'unité (CTR) de commande effectue lors d'un accès en lecture pour le préchargement des lignes (BL, /BL) de bits un déchargement de la ligne (BL) de bits reliée à la cellule (MC) de mémoire à lire, qui suit dans le temps la compensation de charge entre les lignes (BL, /BL) de bits et qui cesse lors d'un accès en écriture.

6. Mémoire intégrée suivant l'une des revendications précédentes
- dans laquelle pendant un accès en lecture, la cellule (MC) de mémoire respective est lue avant une activation de l'amplificateur (SA) de lecture en la reliant de manière conductrice à l'une des lignes (BL, /BL) de bits,
- et dans laquelle pendant un accès en écriture, il s'effectue d'abord une activation de l'amplificateur (SA) de lecture, de sorte que des données à écrire se trouvent déjà sur la paire (BL, /BL) de lignes de bits avant que la cellule (MC) respective de mémoire soit reliée de manière conductrice à l'une des lignes (BL) de bits.
